(19) Europäisches Patentamt
European Patent Office
Office européen des brevets

(11) **EP 1 067 608 B1**

(12) **FASCICULE DE BREVET EUROPEEN**

(45) Date de publication et mention
de la délivrance du brevet:
**09.11.2005 Bulletin 2005/45**

(51) Int Cl.⁷: **H01L 41/04**

(21) Numéro de dépôt: **00401881.8**

(22) Date de dépôt: **30.06.2000**

(54) **Dispositif et procédé de commande d'un actuateur piezo-électrique**

Anordnung und Steuerschaltung eines piezoelektrisches Antriebs

Device and control circuit for a piezoelectric actuator

(84) Etats contractants désignés:
**BE DE**

(30) Priorité: **09.07.1999 FR 9908932**

(43) Date de publication de la demande:
**10.01.2001 Bulletin 2001/02**

(73) Titulaire: **Renault s.a.s.**
**92100 Boulogne Billancourt (FR)**

(72) Inventeurs:
• **Ballesteros, Guillermo**
**77290 Mitry-Mory (FR)**
• **Macua, Eugénio**
**31008 Pampelune (ES)**

(56) Documents cités:
**EP-A- 0 750 104         EP-A- 0 871 230**

## Description

L'invention concerne un dispositif de commande d'un actuateur piézo-électrique piloté électroniquement, et plus particulièrement d'un injecteur de carburant à étage piézo-électrique piloté par le calculateur d'injection électronique du moteur thermique, dans un véhicule automobile, et un procédé de mise en oeuvre de ce dispositif de commande.

Actuellement, l'injection d'essence ou de gasole dans les cylindres d'un moteur thermique, pour véhicule automobile, est assurée par des injecteurs à céramique piézo-électrique aux bornes de laquelle on fait varier la tension de façon à modifier son épaisseur, entre deux positions extrêmes, ce qui a pour conséquence d'ouvrir et de fermer l'injecteur. La céramique piézo-électrique est équivalente à une capacité, qui est classiquement associée à une inductance pour constituer un circuit oscillant.

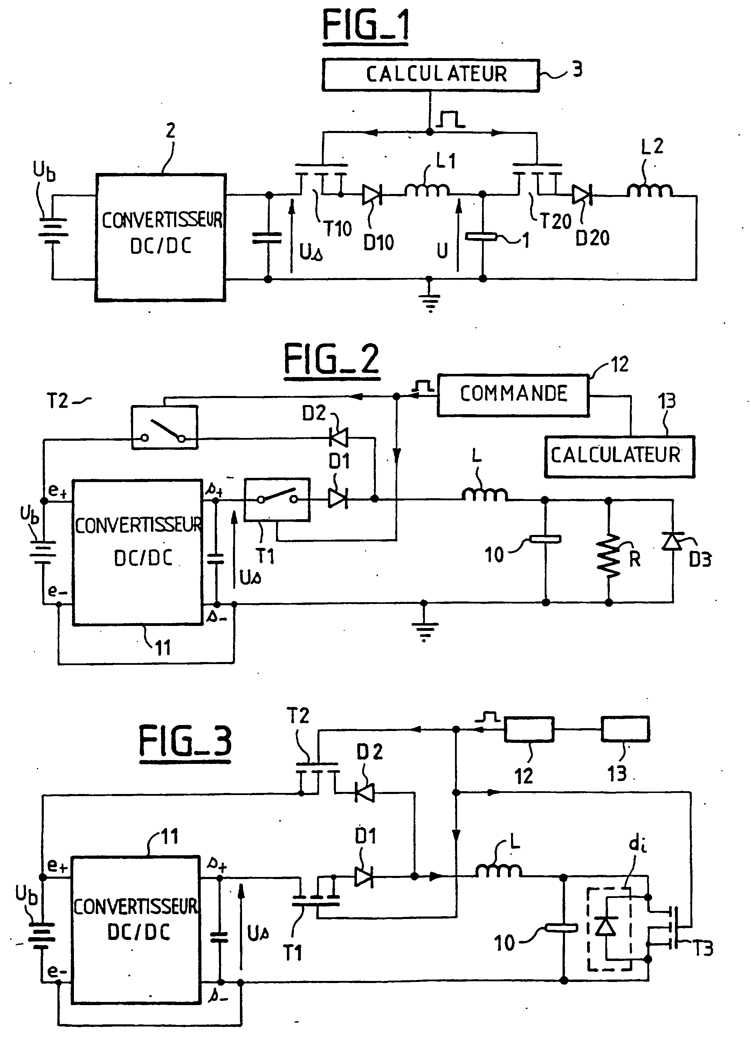

La figure 1 est un schéma électronique d'un dispositif de commande d'une céramique piézo-électrique 1 équivalente à une capacité C, associée à une première inductance $L_1$ pour réaliser un circuit oscillant de charge de la céramique, au double de la tension d'alimentation $U_s$ délivrée par un convertisseur 2 de tension en courant continu DC-DC alimenté lui-même par la basse tension $U_b$ de la batterie, de l'ordre de 12 volts. Un transistor $T_{10}$ de type MOSFET canal N est branché en série avec une diode $D_{10}$, entre le convertisseur 2 et la borne de l'inductance $L_1$ opposée à la céramique. Le transistor $T_{10}$ est piloté en tout ou rien par le calculateur d'injection 3 par exemple. Lorsque le transistor $T_{10}$ est piloté pour être passant, la céramique piézo-électrique 1 se charge en mode oscillant. La tension U à ses bornes est donc sinusoïdale et atteint un maximum égal au double de la tension $U_s$ de sortie du convertisseur. Lorsque cette tension maximale est atteinte aux bornes de la céramique, le courant qui la traverse s'annule et la diode $D_{10}$ se bloque, le transistor $T_{10}$ est alors commandé au blocage. La tension aux bornes de la céramique reste constante.

La décharge de la céramique piézo-électrique se fait à travers un second circuit oscillant, composé de la céramique et d'une seconde inductance $L_2$ branchée à la masse. Un second transistor $T_{20}$ de type MOSFET est branché en série avec une diode $D_{20}$ entre la céramique 1 et l'inductance $L_2$. Lorsque le transistor $T_{20}$ est commandé pour être passant, la capacité de la céramique se décharge sous un mode oscillant à travers la diode $D_{20}$ et l'inductance $L_2$. Lorsque le courant dans la capacité s'annule, la diode $D_{20}$ se bloque et le transistor $T_2$ est commandé au blocage. Alors la céramique piézo-électrique reste chargée à une tension négative égale au double de la tension d'entrée. Un tel dispositif de commande d'une céramique piézo-électrique est décrit dans la demande de brevet japonais JP 6153538, déposée au nom de TOYOTA.

Cette conception actuelle d'un dispositif de commande présente, comme principal inconvénient, la non annulation de la tension aux bornes de la céramique piézo-électrique à la fin du cycle de décharge, en raison des pertes mécaniques dans l'injecteur et des pertes résistives du circuit électrique. Cela pose deux problèmes, d'une part la totalité de l'énergie n'est pas récupérée, et d'autre part la présence d'une charge négative à la fin du cycle de décharge entraîne un mauvais fonctionnement de l'injecteur à céramique.

Pour pallier ces inconvénients, le circuit oscillant de décharge de la capacité de la céramique piézo-électrique n'est plus relié à la masse du convertisseur de tension, mais à son entrée pour assurer l'annulation de la tension aux bornes de la céramique et la récupération totale de l'énergie.

Pour cela, l'objet de l'invention est un dispositif de commande d'un actuateur à céramique piézo-électrique, piloté électroniquement par un signal logique, comprenant un convertisseur de tension en courant continu alimenté en basse tension, un circuit de charge de la céramique piézo-électrique constitué d'une inductance réalisant un circuit oscillant avec la capacité de la céramique, en série avec un interrupteur et une diode, caractérisé en ce que :

- le circuit de décharge de la céramique piézo-électrique est constitué d'une inductance réalisant un second circuit oscillant dont la tension d'entrée est égale à la tension d'entrée du convertisseur de tension par l'intermédiaire d'un second interrupteur associé à une seconde diode en série avec l'inductance et passants dans le sens du courant de décharge, et en ce qu'il comporte:

  - des premiers moyens de maintien de la tension aux bornes de la céramique piézo-électrique à une valeur nulle en fin de décharge et d'annulation du courant dans l'inductance, et

  - des seconds moyens de blocage de la charge de l'élément piézo-électrique par des courants de fuite des interrupteurs après sa décharge (revendication 1).

Selon une autre caractéristique de l'invention, le circuit de décharge est constitué de la même inductance réalisant un second circuit oscillant dont la tension d'entrée est égale à la tension d'entrée du convertisseur de tension par l'intermédiaire d'un second interrupteur associé à une seconde diode en série avec l'inductance et passants dans le sens du courant de décharge.

Un autre objet de l'invention est un procédé de commande d'un actuateur à céramique piézo-électrique par ledit dispositif, caractérisé en ce que le signal logique pilotant les interrupteurs du dispositif est envoyé par un circuit de commande recevant un ordre d'un calculateur de contrôle de l'actuateur, de sorte que le dispositif de commande fonctionne soit en boucle ouverte, soit en boucle fermée, pour assurer une charge complète de la céramique.

Selon une autre caractéristique, le procédé commande l'actuateur en mode régulation de la tension de sortie du convertisseur de tension en fonction des variations des caractéristiques de la céramique piézo-électrique.

Selon une autre caractéristique, le procédé commande l'actuateur à la fois en mode de régulation de la tension de sortie du convertisseur en fonction des caractéristiques de la céramique piézo-électrique et de plus en boucle fermée pour assurer une charge complète de cette céramique.

D'autres caractéristiques et avantages de l'invention apparaîtront à la lecture de la description de deux versions d'un dispositif de commande d'un actuateur piézo-électrique, illustrée par les figures suivantes qui, outre la figure 1 déjà décrite concernant un dispositif de l'art antérieur, sont :

- la figure 2 : une première variante du dispositif de commande d'une céramique piézo-électrique, en boucle ouverte, selon l'invention ;
- la figure 3 : une deuxième variante du dispositif de commande d'une céramique piézo-électrique, en boucle ouverte, selon l'invention ;
- la figure 4 : le schéma équivalent au circuit de charge de la céramique piézo-électrique, selon l'invention ;
- la figure 5 : le schéma équivalent au circuit de décharge de la céramique piézo-électrique, selon l'invention ;
- la figure 6 : le schéma équivalent au circuit d'annulation du courant dans l'inductance du dispositif selon l'invention ;
- les figures 7 et 9 : trois modes de fonctionnement différents du dispositif de commande d'une céramique piézo-électrique, en mode de régulation, selon l'invention ;
- la figure 10 : les courbes d'intensité de courant et de tension lors de la charge puis de la décharge d'une céramique piézo-électrique, selon l'invention.

Les éléments portant les mêmes références sur les différentes figures remplissent les mêmes fonctions en vue des mêmes résultats.

Comme le montre le schéma électronique de la figure 2, le dispositif de commande d'une céramique piézo-électrique 10 selon l'invention comporte un convertisseur 11 de la basse tension d'alimentation $U_b$, qui est celle de la batterie dans le cas d'un véhicule automobile. Ce convertisseur de tension DC-DC en courant continu délivre en sortie une tension $U_s$ qui fixera la tension de charge de la céramique piézo-électrique. Pour une tension d'alimentation de 12 volts, le convertisseur fournit une tension de l'ordre de 100 volts par exemple. Pour obtenir la récupération complète de l'énergie stockée lors de la charge de l'élément piézo-électrique, le convertisseur doit être de type sans isolation, dont la borne négative $e_-$ de la tension d'entrée $U_b$ est reliée à la borne négative $s_-$ de la tension de sortie $U_s$.

Le circuit de charge de l'élément piézo-électrique 10, qui est équivalent à une capacité électrique C, est constitué d'une part par une inductance L réalisant avec la capacité un circuit oscillant, et d'autre part par un interrupteur $T_1$, par exemple un transistor de puissance, de type MOSFET canal N, ou bipolaire ou à effet de champ par exemple, qui assure la charge de la capacité, associé à une diode $D_1$ en série avec le transistor et l'inductance L. Elle est passante dans le sens du courant de charge et assure la fin du cycle de charge de cette capacité par annulation du courant lors de son blocage.

Selon une caractéristique de l'invention, le circuit de décharge de l'élément piézo-électrique est constitué par la même inductance L que le circuit de charge pour réaliser un second circuit oscillant, dont la tension d'entrée est égale à la tension d'entrée $U_b$ du convertisseur de tension 11 par l'intermédiaire d'un deuxième interrupteur $T_2$, par exemple un transistor de puissance, de type MOSFET canal N, dont le drain est relié à une deuxième diode $D_2$ en série avec la borne de l'inductance L opposée à l'élément piézo-électrique. La source du transistor $T_2$ est reliée à la borne positive $e_+$ d'entrée du convertisseur 11. Le transistor $T_2$ assure la décharge de la céramique piézo-électrique et la diode $D_2$ assure la fin du cycle de décharge par annulation du courant lors de son blocage, ce transistor et cette diode étant passants dans le sens du courant de décharge allant de l'inductance L vers l'entrée du convertisseur. Le transistor de puissance $T_2$ peut aussi être de type bipolaire, à effet de champ, ou autre.

Selon une autre caractéristique de l'invention, sont placés, en parallèle, sur la capacité de la céramique, des premiers moyens de maintien de la tension de la céramique à une valeur nulle en décharge et d'annulation du courant dans l'inductance L et des seconds moyens destinés à éviter la charge de la céramique provoquée par les courants de fuite des transistors jouant le rôle d'interrupteurs de puissance.

Selon une première variante de réalisation du dispositif de commande selon l'invention, ces premiers moyens sont constitués par une diode $D_3$ qui reste bloquée jusqu'à ce que la tension de la céramique s'annule, et ces seconds moyens sont constitués par une résistance R. Dans une deuxième variante de réalisation, représentée sur la figure 3, ces deux moyens sont constitués par un transistor de puissance MOSFET $T_3$, possédant une diode interne $d_i$. Ce transistor peut aussi être de type bipolaire, à effet de champ, IGBT ou autre, avec une diode en parallèle dont l'anode est reliée à la masse et la cathode à l'inductance.

Dans les deux variantes de réalisation, les transistors de puissance $T_1$ et $T_2$ des circuits de charge et de décharge de l'élément piézo-électrique sont pilotés en tout ou rien par un signal logique émis par un circuit électronique 12 de commande à partir d'un calculateur 13 de contrôle de l'actuateur, notamment le calculateur d'injection électronique pour un injecteur de carburant dans un moteur de véhicule. De même, dans la deuxième variante de réalisation, le transistor de puissance $T_3$ est piloté par ce même signal logique.

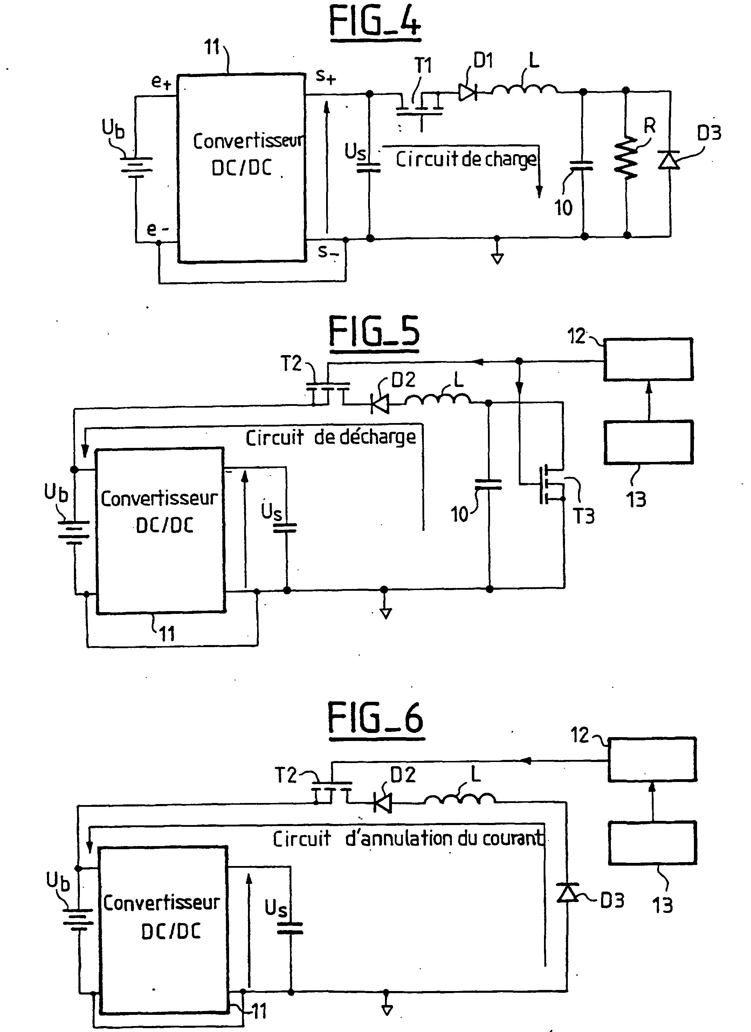

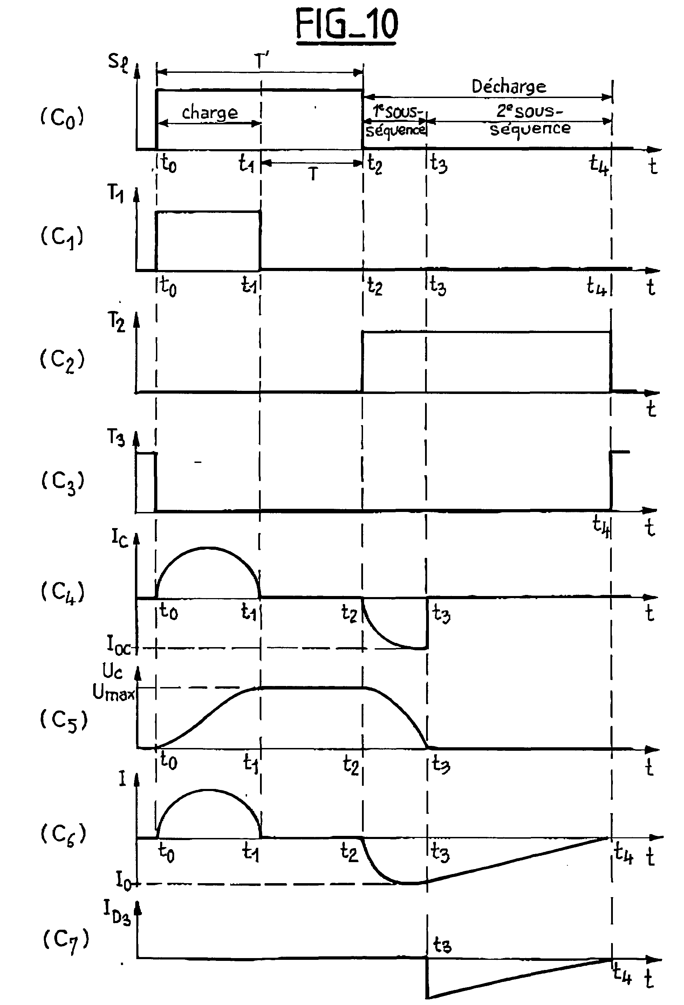

Le fonctionnement du dispositif de commande selon l'invention va être décrit au moyen des figures 4 à 7 en relation avec les chronogrammes de la figure 10.

Le fonctionnement du dispositif de commande d'un injecteur de carburant à céramique piézo-électrique se déroule selon quatre séquences :

- une séquence où l'élément piézo-électrique est au repos, non chargé, donc sans injection de carburant,
- une séquence de charge de l'élément piézo-électrique,
- une séquence d'injection de carburant,
- une séquence de décharge de l'élément piézo-électrique.

Le calculateur électronique 13 de contrôle du moteur thermique émet un ordre d'injection qui répond aux besoins du moteur en quantité de carburant nécessaire et en phasage avec la position du moteur et des soupapes, et se traduit par un signal logique $S_I$ du circuit de commande 12 d'une durée T', représenté par la courbe ($C_0$) de la figure 10, la durée T étant la durée d'injection dans la séquence d'injection du carburant.

Avant l'instant $t_0$ de démarrage de l'injection, donc en séquence sans injection, les transistors $T_1$ et $T_2$ sont bloqués, à l'état 0 ou OFF comme le montrent les courbes respectives ($C_1$) et ($C_2$) de la figure 10.

Dans la première variante de réalisation, la résistance R placée en parallèle sur la céramique piézo-électrique de capacité C est destinée à éviter une charge intempestive de cette céramique à cause des courants de fuite des interrupteurs.

Pour cela, elle doit avoir une valeur déterminée suffisamment élevée pour que son effet soit négligeable pendant les cycles de charge et de décharge de la céramique piézo-électrique, et pour éviter une décharge de cette céramique pendant la période où elle doit rester chargée.

Dans la seconde variante de réalisation, l'interrupteur $T_3$ est amorcé, à l'état ON, avant l'instant $t_0$ de début d'injection (courbe $C_3$) pour fixer à une valeur nulle la tension aux bornes de la céramique piézo-électrique et produire un effet équivalent à la résistance R.

A l'instant $t_0$, lorsque le signal de commande passe de l'état bas 0 à l'état haut 1, le front montant est détecté et le transistor $T_1$ est immédiatement amorcé, passant de l'état 0 à l'état 1. C'est le début de la séquence de charge de l'élément piézo-électrique de l'actuateur.

Le transistor $T_2$ est maintenu bloqué, seul le transistor $T_1$ étant passant.

Dans la deuxième variante de réalisation, le transistor $T_3$ est bloqué à l'instant $t_0$ de détection du front montant du signal de commande.

Lorsque le transistor de charge $T_1$ devient passant, le convertisseur de tension 11 fournissant une haute tension de sortie $U_s$, un courant I, représenté par la courbe ($C_6$), passe à travers le circuit oscillant formé par l'inductance L et la capacité C de la céramique, puisque la diode $D_1$ est placée en série avec l'inductance de façon à être passante lors de la charge de la capacité C.

Cette capacité C se charge jusqu'à une tension théorique $U_{max}$ égale au double de la tension de sortie $U_s$ du convertisseur de tension (courbe $C_5$).

Dans la première variante de réalisation, la diode $D_3$ reste naturellement bloquée donc aucun courant $I_3$ ne la traverse (courbe $C_7$), et la résistance R choisie a une valeur suffisamment élevée pour négliger son influence dans le circuit oscillant lors de ce cycle de chargement.

Dans la deuxième variante de réalisation, puisque le transistor $T_3$ est bloqué, sa diode interne reste aussi naturellement bloquée car la tension drain-source est positive, de sorte que le transistor $T_3$ n'a aucune influence lors de la charge de la céramique.

La figure 4 est le schéma électronique équivalent au circuit de charge de la céramique piézo-électrique dans le premier mode de réalisation. Bien entendu, il suffit de remplacer la résistance R en parallèle avec la diode $D_3$, par le transistor $T_3$ pour obtenir le schéma du circuit de charge dans le cas de la deuxième variante de réalisation.

Comme le montre la courbe $C_6$ de la figure 10, le courant I passant dans l'inductance L est sinusoïdal et s'annule à l'instant $t_1$ de fin du cycle de charge de la capacité C, de même que le courant $I_c$ dans la céramique, représenté sur la courbe $C_4$. Sa valeur maximale est de l'ordre de 15 Ampères. Quand ce courant I s'annule, le courant $I_c$ s'annule aussi et la diode $D_1$ se bloque de sorte que la céramique piézo-électrique reste chargée à une valeur maximale constante $U_{max}$. A cet instant $t_1$, le circuit électronique 12 commande le blocage du transistor de charge $T_1$ qui repasse à l'état O.

La séquence d'injection de carburant par ouverture de l'actuateur piézo-électrique a lieu entre la séquence de charge de la capacité se terminant à l'instant $t_1$ et la séquence de décharge débutant à l'instant $t_2$. Pour cela, la tension aux bornes de la céramique piézo-électrique doit être maintenue constante. Les transistors de puissance $T_1$ et $T_2$ restent bloqués à l'état bas pour assurer un courant nul à travers la céramique, entre $t_1$ et $t_2$.

Dans le cas de la deuxième variante de réalisation, le calculateur 11 maintient le transistor $T_3$ bloqué pour éviter la décharge de cette céramique à travers celui-ci.

La séquence de décharge débute à l'instant $t_2$ de passage du signal de commande de l'état 1 à l'état 0. Lors de la détection du front descendant de ce signal de commande $S_l$, le transistor de décharge $T_2$ est immédiatement amorcé et devient passant, alors que le transistor de charge $T_1$ est maintenu bloqué à l'état 0, la tension entre sa grille et sa source étant maintenue à zéro. De plus, pendant cette décharge, le transistor $T_3$ de la deuxième variante de réalisation est maintenu à l'état bloqué, pour permettre la décharge de la capacité à travers le transistor $T_2$ et la diode associée $D_2$.

Cette séquence de décharge se divise en deux sous-séquences :

- une décharge oscillante,
- une annulation du courant dans l'inductance L du circuit oscillant LC.

Lors de la décharge oscillante, le circuit oscillant LC, créé au moment du passage en conduction du transistor de décharge $T_2$, est relié à la borne d'entrée $e_+$ du convertisseur en tension 11.

L'état initial du circuit oscillant est différent de celui de la charge puisque la capacité est chargée et que sa tension d'entrée est égale à la basse tension de la batterie $U_b$. Donc la tension aux bornes du circuit oscillant ne va tendre ni vers une valeur nulle, ni vers une valeur négative, comme c'était le cas dans l'art antérieur.

La décharge oscillante de la capacité C piézoélectrique se produit entre les instants $t_2$ et $t_3$, c'est-à-dire entre la détection du front descendant du signal de commande et l'annulation de la tension aux bornes de la capacité C. Pendant cette séquence, le courant $I_c$ dans la capacité décroît sinusoïdalement de zéro vers une valeur $I_{OC}$ négative, voisine du minimum et le courant I dans l'inductance L décroît sinusoïdalement aussi de zéro jusqu'à une valeur négative $I_0$ égale à $I_{OC}$.

A l'instant $t_3$ d'annulation de la tension $U_C$ aux bornes de la capacité C, dans la première variante de réalisation, la diode $D_3$ se met en conduction et ainsi empêche cette tension de devenir négative en la maintenant à une valeur nulle. Dans la deuxième variante de réalisation, c'est la diode interne du transistor de puissance $T_3$ qui joue le même rôle.

La figure 5 est le schéma électronique équivalent au circuit de décharge de la céramique piézo-électrique dans la deuxième variante de réalisation. Il suffit de remplacer le transistor $T_3$ par la résistance R en parallèle avec la diode $D_3$ pour obtenir le schéma du circuit de décharge selon la première variante de réalisation.

La deuxième sous-séquence débute à l'instant $t_3$ d'annulation de la tension $U_c$ aux bornes de la céramique piézo-électrique, alors que l'intensité I du courant dans l'inductance L n'est pas nulle.

Cette inductance L est soumise à une tension positive, égale à la tension $U_b$ d'alimentation du convertisseur de tension 11, qui s'oppose au sens du courant. Le courant I décroît alors linéairement avec le temps à partir de l'instant $t_3$, en négligeant les résistances des interrupteurs, à travers les deux diodes $D_2$ et $D_3$ dans la première variante de réalisation et à travers la diode $D_2$ et la diode interne du transistor $T_3$ dans la deuxième variante :

$$I(t) = I_0 - (U_b/L)*t$$

$I_0$ étant la valeur du courant I à l'instant $t_3$.

La figure 6 est le schéma électronique équivalent du circuit d'annulation du courant dans l'inductance L, sous une tension constante.

A l'instant $t_4$ d'annulation du courant I, les diodes $D_2$ et $D_3$, ou $D_2$ et la diode interne du transistor $T_3$, se bloquent naturellement, empêchant ainsi le changement du sens du courant. Au même instant, le transistor de décharge $T_2$ est commandé au blocage.

Dans la première variante de réalisation, la résistance R évite la charge de la céramique provoquée par des courants de fuite des interrupteurs.

Dans la deuxième variante de réalisation, le transistor $T_3$ est piloté à l'amorçage pour assurer une tension nulle aux bornes de la céramique piézo-électrique.

Dans les deux variantes de réalisation qui viennent d'être décrites, les interrupteurs $T_1$, $T_2$ et $T_3$ sont pilotés par le circuit électronique de commande 12 en boucle ouverte, à partir du signal de commande d'un calculateur de contrôle moteur par exemple.

Selon un premier mode de fonctionnement, le dispositif de commande d'un actuateur piézo-électrique selon l'invention fonctionne en boucle ouverte, le circuit de commande 12 recevant simplement un signal du calculateur électronique pour piloter les transistors.

Selon un deuxième mode, le dispositif fonctionne en boucle fermée afin de régler la tension de sortie $U_s$ du convertisseur de tension DC-DC 11 dans le but d'assurer une charge complète de la céramique piézoélectrique. Pour cela, le circuit de commande 12 reçoit en entrée, en plus d'un ordre du calculateur 13 de contrôle de l'actuateur, les informations sur le courant I circulant à travers l'inductance L et sur la tension $U_c$ aux bornes de la céramique. Ce mode de fonctionnement peut s'appliquer aux deux variantes de réalisation du dispositif.

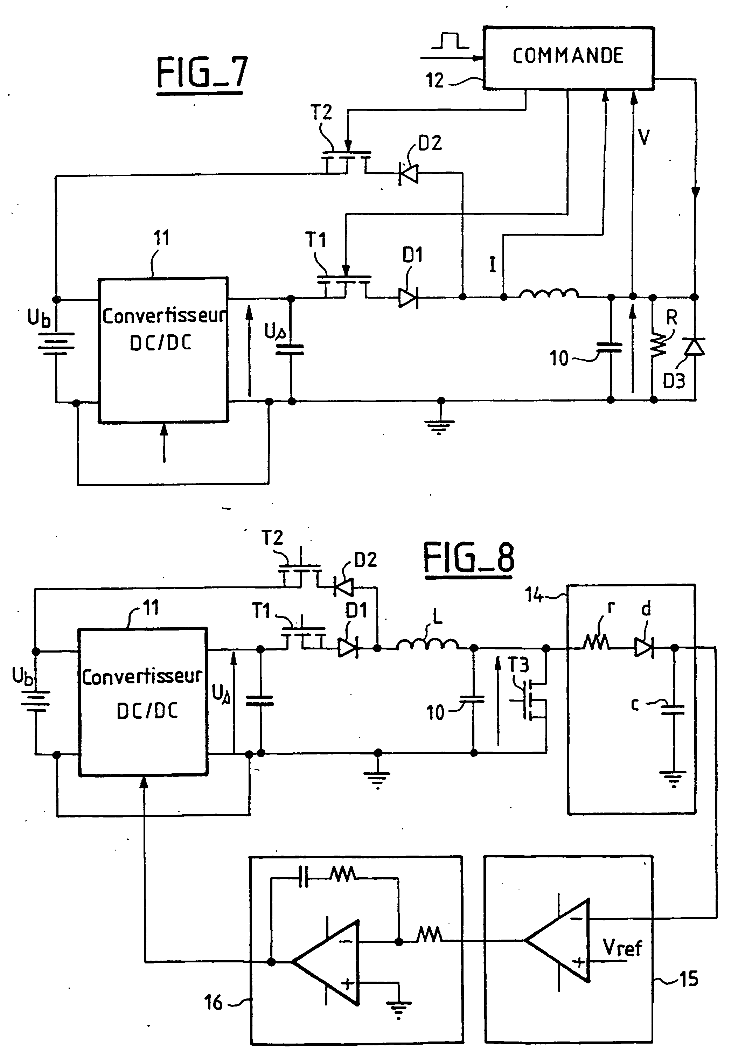

La figure 7 est un schéma électronique du deuxième mode de fonctionnement en boucle fermée du dispositif de commande selon l'invention, appliqué à la première variante de réalisation.

Selon un troisième mode de fonctionnement, le dispositif de commande fonctionne en mode de régulation de la tension du convertisseur de tension 11, en fonction des variations des caractéristiques de la céramique piézo-électrique que cette régulation soit analogique ou numérique. Dans le cas d'une structure analogique, le circuit de régulation comporte trois éléments, comme le montre la figure 8 qui correspond à la deuxième variante de réalisation.

Tout d'abord, un détecteur de crête 14 est branché en parallèle sur la céramique piézo-électrique C, destiné à contrôler la valeur de sa charge électrique. Il est constitué par exemple d'une résistance r en série avec une diode d, associée à une capacité c reliée à la masse.

Le détecteur de crête 14 délivre un signal de sortie à l'entrée d'un comparateur 15, destiné à comparer la tension maximale atteinte aux bornes de la céramique avec une tension de consigne $V_{réf}$.

Son signal de sortie est ensuite envoyé à l'entrée d'un régulateur 16 proportionnel-intégral, destiné à commander la tension de sortie $U_s$ du convertisseur DC-DC.

Selon un quatrième mode de fonctionnement, le dispositif peut à la fois réguler la tension de sortie du convertisseur de tension 11 pour prendre en compte les variations des caractéristiques de cet élément dans le temps et fonctionner en boucle fermée pour assurer une charge totale de l'élément piézo-électrique.

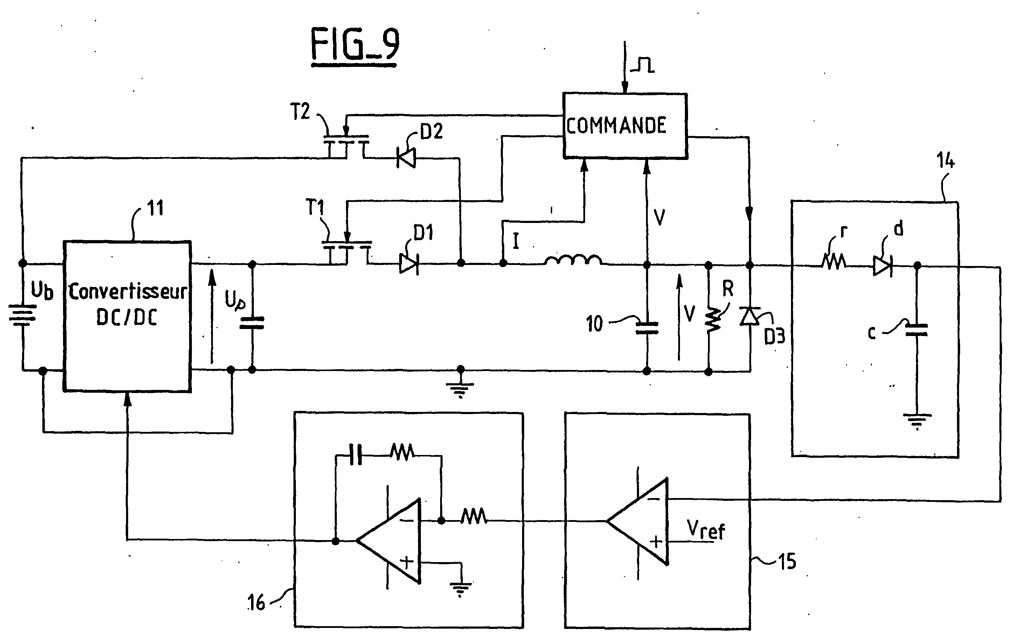

La figure 9 est un schéma électronique du dispositif de commande selon ce quatrième mode de fonctionnement, réalisé d'après la deuxième variante avec le transistor $T_3$.

L'invention a pour avantage de décharger complètement la céramique piézo-électrique de l'actuateur, assurant ainsi un bon fonctionnement de l'actuateur. De plus, elle assure la récupération de l'énergie électrique stockée dans la céramique piézo-électrique.

## Revendications

1. Dispositif de commande d'un actionneur à céramique piézo-électrique (10), piloté électroniquement par un signal logique, comprenant un convertisseur de tension (11) en courant continu alimenté en basse tension, un circuit de charge de la céramique piézo-électrique constitué d'une inductance (L) réalisant un circuit oscillant avec la capacité de la céramique (10), en série avec un interrupteur (T1) et une diode (D1), **caractérisé en ce que** :

   - le circuit de décharge de la céramique piézo-électrique est constitué d'une inductance réalisant un second circuit oscillant dont la tension d'entrée est égale à la tension d'entrée du convertisseur (11) de tension par l'intermédiaire d'un second interrupteur ($T_2$) associé à une seconde diode ($D_2$) en série avec l'inductance et passants dans le sens du courant de décharge,

      et **en ce qu'**il comporte:

   - des premiers moyens de maintien de la tension aux bornes de la céramique piézo-électrique à une valeur nulle en décharge et d'annulation du courant (I) dans l'inductance (L), et

   - des seconds moyens de blocage de la charge de la céramique piézo-électrique par des courants de fuite des interrupteurs après sa décharge.

2. Dispositif de commande selon la revendication 1, **caractérisé en ce que** le circuit de décharge de la céramique piézo-électrique est constitué de la même inductance (L) que le circuit de charge pour réaliser un second circuit oscillant dont la tension d'entrée est égale à la tension d'entrée du convertisseur (11) de tension par l'intermédiaire d'un second interrupteur ($T_2$) associé à une seconde diode ($D_2$) en série avec l'inductance (L) et passants dans le sens du courant de décharge.

3. Dispositif de commande selon la revendication 1, **caractérisé en ce que** le convertisseur (11) de tension, fonctionnant en courant continu, est sans isolation, la borne négative ($e_-$) de la tension d'entrée ($U_b$) étant reliée à la borne négative ($s_-$) de la tension de sortie ($U_s$).

4. Dispositif de commande selon la revendication 1, **caractérisé en ce que** les moyens d'annulation du courant (I) dans l'inductance (L) sont constitués par une diode ($D_3$) en parallèle sur l'élément piézo-électrique (10), qui est bloquée pendant le cycle de charge de la céramique piézo-électrique et pendant le cycle de décharge jusqu'à l'instant d'annulation de la tension aux bornes de la céramique, instant à partir duquel elle devient passante pour maintenir cette tension nulle et laisser passer le courant (I) dans l'inductance jusqu'à ce que ce dernier s'annule.

5. Dispositif de commande selon la revendication 1, **caractérisé en ce que** les moyens de blocage de la charge de l'élément piézo-électrique (10) par d'éventuels courants de fuite des interrupteurs après sa décharge, sont constitués par une résistance (R) en parallèle sur l'élément, de valeur déterminée suffisamment élevée pour que son effet soit négligeable pendant les cycles de charge et de décharge de l'élément et pour bloquer une décharge éventuelle de cet élément pendant la période où il doit rester chargé.

6. Dispositif de commande selon la revendication 1, **caractérisé en ce** les premiers moyens de maintien de la tension aux bornes de la céramique piézo-électrique à une valeur nulle en décharge et d'annulation du courant (I) dans l'inductance (L), et les seconds de blocage de la charge de la céramique piézo-électrique par des courants de fuite des interrupteurs après sa décharge. sont constitués par un transistor de puissance MOSFET ($T_3$), de diode interne ($d_i$).

**7.** Dispositif de commande selon la revendication 1, **caractérisé en ce que** les interrupteurs ($T_1$ et $T_2$) des circuits respectivement de charge et de décharge de la céramique piézo-électrique (10) sont des transistors de puissance de type MOSFET canal N.

**8.** Dispositif de commande selon l'une des revendications 1 à 6, **caractérisé en ce qu'**il comporte de plus un circuit de régulation de la tension du convertisseur de tension (11) constitué par :

- un détecteur de crête (14), branché en parallèle sur la céramique piézo-électrique (10) et destiné à contrôler la valeur de sa charge électrique ;
- un comparateur (15) de la tension maximale atteinte aux bornes de la céramique (10) avec une tension de consigne ($V_{réf}$) ;
- un régulateur (16) proportionnel intégral destiné à réguler la tension de sortie ($U_s$) du convertisseur de tension (11) à partir d'un signal délivré par le comparateur (15).

**9.** Procédé de mise en oeuvre du dispositif de commande selon l'une des revendications 1 à 6, **caractérisé en ce qu'**il comporte les étapes suivantes :

- la charge de la céramique (10), démarrant à la détection du front montant du signal logique ($S_l$) émis par le circuit de commande (12) et au cours de laquelle l'interrupteur ($T_1$) du circuit de charge de la céramique (10) est passant, l'interrupteur ($T_2$) du circuit de décharge de ladite céramique (10) étant bloqué et les moyens d'annulation du courant dans l'inductance (L) étant bloqués ;
- l'ouverture de l'actionneur à l'instant d'annulation du courant ($I_c$) dans la céramique (10), avec maintien de la tension maximale ($U_{max}$) constante à ses bornes par blocage de l'interrupteur ($T_1$) et de la diode ($D_1$) du circuit de charge de la céramique (10) ;
- la décharge de la céramique (10), démarrant à la détection du front descendant du signal logique ($S_l$), et au cours de laquelle l'interrupteur ($T_2$) devient passant et les moyens d'annulation du courant (I) dans l'inductance (L) deviennent à leur tour passant à l'instant d'annulation de la tension ($U_c$) aux bornes de la céramique, jusqu'à l'instant d'annulation du courant (I).

**10.** Procédé de mise en oeuvre du dispositif de commande selon l'une des revendications 1 à 6, **caractérisé en ce que** le signal logique ($S_l$) pilotant les interrupteurs ($T_1$, $T_2$, $T_3$) du dispositif est envoyé par un circuit de commande (12) recevant un ordre d'un calculateur (13) de contrôle de l'actionneur à céramique piézo-électrique, de sorte que le dispositif de commande fonctionne en boucle ouverte.

**11.** Procédé de mise en oeuvre du dispositif de commande selon l'une des revendications 1 à 6, **caractérisé en ce que** le circuit (12) de commande des interrupteurs reçoit en entrée d'une part un ordre du calculateur (13) de contrôle de l'actionneur et d'autre part une information sur le courant (I) circulant à travers l'inductance (L) des circuits de charge et de décharge et une information sur la tension ($U_c$) aux bornes de la céramique piézo-électrique (10), pour fonctionner en boucle fermée en ajustant la tension de sortie ($U_s$) du convertisseur de tension (11) pour une charge complète de la céramique.

**12.** Procédé de mise en oeuvre du dispositif de commande selon la revendication 10, **caractérisé en ce que** le dispositif de commande de l'actionneur fonctionne en mode de régulation de la tension de sortie ($U_s$) du convertisseur de tension (11) en fonction des variations des caractéristiques de la céramique piézo-électrique (10), par mesure de la valeur de sa charge électrique au moyen d'un détecteur de crête (14), suivie d'une comparaison de la tension maximale aux bornes de la céramique avec une consigne ($V_{réf}$), dont le résultat est envoyé sur un régulateur (16) proportionnel-intégral qui commande la tension de sortie ($U_s$) du convertisseur (11).

**13.** Procédé de mise en oeuvre du dispositif de commande selon l'une des revendications 1 à 6, **caractérisé en ce que** la tension de sortie (Us) du convertisseur de tension (11) est régulée pour, d'une part, une charge complète de la céramique (10) piézo-électrique par le dispositif (12) de commande des interrupteurs qui reçoit d'une part un signal du calculateur (13) de contrôle de l'actionneur et d'autre part des informations sur le courant (I) dans l'inductance (L) et sur la tension ($U_c$) aux bornes de la céramique (10) piézo-électrique, et pour, d'autre part, tenir compte des variations des caractéristiques de la céramique par le circuit de régulation de la tension de sortie ($U_s$).

**Patentansprüche**

**1.** Steuervorrichtung eines Aktuators mit piezoelektrischer Keramik (10), elektronisch gesteuert durch ein logisches Signal, umfassend einen Gleichspannungswandler (11), der mit Niederspannung versorgt wird, eine Schaltung zur Ladung der piezoelektrischen Keramik, die aus einer Induktivität (L) besteht, welche eine oszillierende Schaltung mit der Kapazität der Keramik (10) realisiert, in Serie mit einem Schalter ($T_1$) und einer Diode (D1), **dadurch gekennzeichnet, dass**:

- die Entladeschaltung der piezoelektrischen Keramik aus einer Induktivität besteht, die eine zweite oszillierende Schaltung realisiert, deren Eingangsspannung gleich der Eingangsspannung des Spannungswandlers (11) ist, über einen zweiten Schalter ($T_2$), der einer zweiten Diode ($D_2$) zugeordnet ist, in Reihe mit der Induktivität und in der Richtung des Entladungsstroms durchlässig,

    und **dadurch**, **dass** sie aufweist:

- erste Mittel zum Halten der Spannung an den Anschlüssen der piezoelektrischen Keramik auf einen Nullwert beim Entladen und zur Annullierung des Stroms (I) in der Induktivität (L), und
- zweite:Mittel zur Blockierung der Ladung der piezoelektronischen Keramik durch die Ableitströme der Schalter nach ihrer Entladung.

2. Steuervorrichtung gemäß Anspruch 1, **dadurch gekennzeichnet, dass** die Entladeschaltung der piezoelektrischen Keramik aus derselben Induktivität (L) wie die Ladeschaltung besteht, um eine zweite oszillierende Schaltung zu realisieren, deren Eingangsspannung gleich der Eingangsspannung des Spannungswandlers (11) ist, über einen zweiten Schalter ($T_2$), der einer zweiten Diode ($D_2$) zugeordnet ist, in Reihe mit der Induktivität (L) und durchlässig in der Richtung des Entladestroms.

3. Steuervorrichtung gemäß Anspruch 1, **dadurch gekennzeichnet, dass** der Spannungswandler (11), der mit Gleichspannung arbeitet, ohne Isolierung ist, wobei der negative Anschluss (e-) der Eingangsspannung ($U_b$) mit dem negativen Anschluss (s-) der Ausgangsspannung ($U_s$) verbunden ist.

4. Steuervorrichtung gemäß Anspruch 1, **dadurch gekennzeichnet, dass** die Mittel zur Annullierung des Stroms (I) in der Induktivität (L) aus einer Diode ($D_3$) bestehen, parallel zum piezoelektrischen Element (10), das während des Ladezyklus der piezoelektrischen Keramik und während des Entladezyklus bis zum Zeitpunkt der Annullierung der Spannung an den Anschlüssen der Keramik blockiert ist, welcher ein Zeitpunkt ist, ab dem sie durchlässig wird, um diese Nullspannung aufrecht zu erhalten und den Strom (I) in der Induktivität durchzulassen, bis letzterer sich annulliert.

5. Steuervorrichtung gemäß Anspruch 1, **dadurch gekennzeichnet, dass** die Mittel zur Blockierung der Ladung des piezoelektrischen Elements (10) durch eventuelle Ableitströme der Schalter nach seiner Entladung aus einem Widerstand (R) bestehen, parallel zum Element, mit einem vorbestimmten Wert, der hoch genug ist, damit seine Wirkung während der Lade- und Entladezyklen des Elements vernachlässigbar ist, und zum Blockieren einer eventuellen Entladung dieses Elements während der Periode, in der es geladen bleiben muss.

6. Steuervorrichtung gemäß Anspruch 1, **dadurch gekennzeichnet, dass** die ersten Mittel zum Halten der Spannung an den Anschlüssen der piezoelektrischen Keramik auf einen Nullwert beim Entladen und zur Annullierung des Stroms (I) in der Induktivität (L) und die zweiten zur Blockierung der Ladung der piezoelektrischen Keramik durch Ableitströme der Schalter nach ihrer Entladung aus einem MOSFET-Leistungstransistor ($T_3$) bestehen, mit interner Diode ($d_i$).

7. Steuervorrichtung gemäß Anspruch 1, **dadurch gekennzeichnet, dass** die Unterbrecher ($T_1$ und $T_2$) der jeweiligen Lade- und Entladeschaltung der piezoelektrischen Keramik (10) Leistungstransistoren vom Kanal N MOSFET Typ sind.

8. Steuervorrichtung gemäß einem der Ansprüche 1 bis 6, **dadurch gekennzeichnet, dass** sie darüber hinaus eine Schaltung zur Regulierung der Spannung des Spannungswandlers (11) aufweist, die besteht aus:

- einem Entdecker von Spitzen (14), parallel geschaltet zur piezoelektrischen Keramik (10) und dazu bestimmt, den Wert ihrer elektrischen Ladung zu kontrollieren;
- einem Vergleicher (15) der maximal erreichten Spannung an den Anschlüssen der Keramik (10) mit einer Anweisungsspannung ($V_{ref}$);
- einem integralen, proportionalen Regler (16), dazu bestimmt, die Ausgangsspannung ($U_s$) des Spannungswandlers (11) auf der Grundlage eines Signals zu regeln, das durch den Vergleicher (15) geliefert wird.

9. Verfahren zur Umsetzung einer Steuervorrichtung gemäß einem der Ansprüche 1 bis 6, **dadurch gekennzeichnet, dass** es die folgenden Schritte aufweist:

- die Ladung der Keramik (10), startend bei der Entdeckung der ansteigenden Flanke des logischen Signals ($S_1$), das durch die Steuerschaltung (12) ausgegeben wird, und im Laufe derer der Schalter ($T_1$) der Ladeschaltung der Keramik (10) durchlässig ist, wobei der Schalter ($T_2$) der Entladeschaltung der Keramik (10) blockiert ist und die Mittel zur Annullierung des Stroms in der Induktivität (L) blockiert sind;
- die Öffnung des Schalters im Zeitpunkt der Annullierung des Stroms ($I_c$) in der Keramik (10), unter Aufrechterhaltung der konstanten maximalen Spannung ($U_{max}$) an ihren Anschlüssen durch Blokkierung durch den Schalter ($T_1$) und der Diode ($D_1$) der Ladeschaltung der Keramik (10);

- die Entladung der Keramik (10), startend bei der Entdeckung der abfallenden Flanke des logischen Signals ($S_1$), im Laufe derer der Schalter ($T_2$) durchlässig wird und die Mittel zur Annullierung des Stroms (I) in der Induktivität (L) ihrerseits im Zeitpunkt der Annullierung der Spannung ($U_c$) an den Anschlüssen der Keramik durchlässig werden, bis zum Zeitpunkt der Annullierung des Stroms (I).

10. Verfahren der Umsetzung der Steuervorrichtung gemäß einem der Ansprüche 1 bis 6, **dadurch gekennzeichnet, dass** das logische Signal ($S_1$), das die Schalter ($T_1$, $T_2$, $T_3$) der Vorrichtung steuert, von einer Steuerschaltung (12) geschickt wird, die einen Befehl von einem Rechner (13) zur Steuerung des Aktuators mit piezoelektrischer Keramik empfängt, so dass die Steuervorrichtung mit offenem Kreis arbeitet.

11. Verfahren zur Umsetzung der Steuervorrichtung gemäß einem der Ansprüche 1 bis 6, **dadurch gekennzeichnet, dass** die Schaltung (12) zur Steuerung der Schalter am Eingang einerseits einen Befehl des Rechners (13) zur Steuerung des Aktuators empfängt und andererseits eine Information über den Strom (I), der durch die Induktivität (L) der Lade- und Entladeschaltungen fließt, und eine Information über die Spannung ($U_c$) an den Anschlüssen der piezoelektrischen Keramik (10), zum Arbeiten in geschlossenem Kreis und bei Anpassung der Ausgangsspannung ($U_s$) des Spannungswandlers (11) für eine komplette Entladung der Keramik.

12. Verfahren zur Durchführung der Steuervorrichtung gemäß Anspruch 10, **dadurch gekennzeichnet, dass** die Steuervorrichtung des Aktuators im Modus der Regelung der Ausgangsspannung ($U_s$) des Spannungswandlers (11) funktioniert, in Abhängigkeit von den Schwankungen der Eigenschaften der piezoelektrischen Keramik (10), durch den Wert ihrer elektrischen Ladung mittels eines Entdeckers von Spitzen (14), gefolgt von einem Vergleich der maximalen Spannung an den Anschlüssen der Keramik mit einer Anweisung ($V_{ref}$), dessen Ergebnis an einen integral-proportionalen Regler (16) geschickt wird, der die Ausgangsspannung ($U_s$) des Wandlers (11) steuert.

13. Verfahren zur Umsetzung der Steuervorrichtung gemäß einem der Ansprüche 1 bis 6, **dadurch gekennzeichnet, dass** die Ausgangsspannung ($U_s$) des Spannungswandlers (11) geregelt wird, einerseits für eine vollständige Ladung der piezoelektrischen Keramik (10) durch die Vorrichtung (12) zur Steuerung der Schalter, die einerseits ein Signal des Rechners (13) zur Steuerung des Aktuators empfängt und andererseits Informationen über den Strom (I) in der Induktivität (L) und über die Spannung ($U_c$) an den Anschlüssen der piezoelektrischen Keramik (10), und um andererseits den Variationen der Eigenschaften der Keramik durch die Schaltung zur Regelung der Ausgangsspannung ($U_s$) Rechnung zu tragen.

## Claims

1. Control device for a piezoelectric ceramic actuator (10), controlled electronically by a logic signal, comprising a low-voltage direct-current voltage converter (11), a piezoelectric ceramic charging circuit made up of an inductor (L) forming an oscillating circuit with the capacitor of the ceramic (10), in series with a switch (T1) and a diode (D1), **characterized in that**:

   - the piezoelectric ceramic discharging circuit is made up of an inductor forming a second oscillating circuit whose input voltage is equal to the input voltage of the voltage converter (11) by means of a second switch ($T_2$) connected to a second diode ($D_2$) in series with the inductor and open in the direction of the discharging current,

   and **in that** it comprises:

   - first means for keeping the voltage at the terminals of the piezoelectric ceramic at a zero value when discharging and cancelling out the current (I) in the inductor (L), and
   - second means for preventing charging of the piezoelectric ceramic by leakage currents from the switches after it has been discharged.

2. Control device according to claim 1, **characterized in that** the piezoelectric ceramic discharging circuit is made up of the same inductor (L) as the charging circuit in order to form a second oscillating circuit whose input voltage is equal to the input voltage of the voltage converter (11) by means of a second switch ($T_2$) connected to a second diode ($D_2$) in series with the inductor (L) and open in the direction of the discharging current.

3. Control device according to claim 1, **characterized in that** the voltage converter (11), operating on direct current, is not insulated, the negative terminal ($e\_$) of the input voltage ($U_b$) being connected to the negative terminal ($s\_$) of the output voltage ($U_s$).

**4.** Control device according to claim 1, **characterized in that** the means for cancelling out the current (I) in the inductor (L) are made up of a diode ($D_3$) in parallel on the piezoelectric element (10), which is closed during the piezoelectric ceramic charging cycle and during the discharging cycle until the moment the voltage at the terminals of the ceramic is cancelled out, from which moment it opens in order to maintain this zero voltage and allow the current (I) to flow into the inductor until the current is cancelled out.

**5.** Control device according to claim 1, **characterized in that** the means for preventing the piezoelectric element (10) from being charged by possible leakage currents from the switches after it has been discharged, comprise a resistor (R) in parallel on the element, with a set value which is sufficiently high for its effect to be negligible during the element charging and discharging cycles and to prevent any discharging of this element during the period when it should remain charged.

**6.** Control device according to claim 1, **characterized in that** the first means for keeping the voltage at the terminals of the piezoelectric ceramic at zero when discharging and cancelling out the current (I) in the inductor (L), and the second means for preventing the piezoelectric ceramic from being charged by leakage currents from the switches after it has been discharged comprise a MOSFET power transistor ($T_3$), with an internal diode ($d_i$).

**7.** Control device according to claim 1, **characterized in that** the switches ($T_1$ and $T_2$) of the charging and discharging circuits respectively of the piezoelectric ceramic (10) are N-channel MOSFET type power transistors.

**8.** Control device according to one of claims 1 to 6, **characterized in that** it also comprises a circuit for regulating the voltage of the voltage converter (11) made up of:

- a peak detector (14), connected in parallel on the piezoelectric ceramic (10) and intended to control the value of its electric charge;
- a comparator (15) of the maximum voltage reached at the terminals of the ceramic (10) with a reference voltage ($V_{ref}$);
- a proportional-integral regulator (16) intended to regulate the output voltage ($U_s$) of the voltage converter (11) based on a signal delivered by the comparator (15).

**9.** Method of implementing the control device according to one of claims 1 to 6, **characterized in that** it involves the following stages:

- charging the ceramic (10), starting by detecting the rising front of the logic signal ($S_1$) emitted by the control circuit (12) and during which the switch ($T_1$) of the charging circuit of the ceramic (10) is open, the switch ($T_2$) of the discharging circuit of the said ceramic (10) being closed and the means of cancelling out the current in the inductor (L) being closed;

- opening the actuator at the moment when the current ($I_c$) is cancelled out in the ceramic (10), the maximum voltage ($U_{max}$) being kept constant at its terminals by closing the switch ($T_1$) and the diode ($D_1$) of the charging circuit of the ceramic (10);

- discharging the ceramic (10), starting by detecting the falling front of the logic signal ($S_1$), and during which the switch ($T_2$) opens and the means of cancelling out the current (I) in the inductor (L) in turn open at the moment when the voltage ($U_c$) is cancelled out at the terminals of the ceramic, until the moment the current (I) is cancelled out.

**10.** Method of implementing the control device according to one of claims 1 to 6, **characterized in that** the logic signal ($S_1$) controlling the switches ($T_1$, $T_2$, $T_3$) of the device is sent by a control circuit (12) receiving an order from a computer (13) controlling the piezoelectric ceramic actuator, so that the control device operates in open-loop mode.

**11.** Method of implementing the control device according to one of claims 1 to 6, **characterized in that** the switch control circuit (12) receives as input on the one hand an order from the actuator-control computer (13) and on the other hand information on the current (I) flowing through the inductor (L) of the charging and discharging circuits as well as information on the voltage ($U_c$) at the terminals of the piezoelectric ceramic (10), in order to operate in closed-loop mode by regulating the output voltage ($U_s$) of the voltage converter (11) to completely charge the ceramic.

**12.** Method of implementing the control device according to claim 10, **characterized in that** the actuator control device operates in a mode to regulate the output voltage ($U_s$) of the voltage converter (11) depending on the variations in the characteristics of the piezoelectric ceramic (10), by measuring the value of its electric charge using a peak detector (14), then comparing the maximum voltage at the terminals of the ceramic with a reference voltage ($V_{ref}$), the result of which is sent to a proportional-integral regulator (16) which controls the output voltage ($U_s$) of the converter (11).

**13.** Method of implementing the control device according to one of claims 1 to 6, **characterized in that** the output voltage ($U_s$) of the voltage converter (11) is regulated, on the one hand, so that the piezoelectric ceramic (10) is fully charged by the switch control device (12) which receives on the one hand a signal from the actuator-control computer (13) and on the other hand information on the current (I) in the inductor (L) and on the voltage ($U_c$) at the terminals of the piezoelectric ceramic (10), and, on the other hand, so that the output voltage ($U_s$) regulator circuit takes account of the variations in the characteristics of the ceramic.

FIG_1

FIG_2

FIG_3

## FIG_4

11

$e_+$   $s_+$   T1   D1   L

$U_b$   Convertisseur DC/DC   $U_s$   Circuit de charge   R   D3

$e_-$   $s_-$   10

## FIG_5

T2   D2   L   12

Circuit de décharge

$U_b$   Convertisseur DC/DC   $U_s$   10   T3   13

11

## FIG_6

T2   D2   L   12

Circuit d'annulation du courant

$U_b$   Convertisseur DC/DC   $U_s$   D3   13

11

## FIG_7

## FIG_8

## FIG_9

EP 1 067 608 B1

## FIG_10